(19) Europäisches Patentamt / European Patent Office / Office européen des brevets

(11) **EP 2 459 497 B1**

(12) **EUROPÄISCHE PATENTSCHRIFT**

(45) Veröffentlichungstag und Bekanntmachung des Hinweises auf die Patenterteilung:
**28.12.2016 Patentblatt 2016/52**

(51) Int Cl.:
**C04B 35/468** (2006.01)    **C04B 35/475** (2006.01)
**H01L 41/187** (2006.01)

(21) Anmeldenummer: **10740203.4**

(22) Anmeldetag: **29.07.2010**

(86) Internationale Anmeldenummer:
**PCT/EP2010/061053**

(87) Internationale Veröffentlichungsnummer:
**WO 2011/012682 (03.02.2011 Gazette 2011/05)**

(54) **PIEZOELEKTRISCHE KERAMIKZUSAMMENSETZUNG, VERFAHREN ZUR HERSTELLUNG DER ZUSAMMENSETZUNG UND ELEKTRISCHES BAUELEMENT, UMFASSEND DIE ZUSAMMENSETZUNG**

PIEZO-ELECTRIC CERAMIC COMPOSITION, METHOD FOR PRODUCING THE COMPOSITION, AND ELECTRIC COMPONENT COMPRISING THE COMPOSITION

COMPOSITION CÉRAMIQUE PIÉZO-ÉLECTRIQUE, PROCÉDÉ DE FABRICATION DE LADITE COMPOSITION, ET COMPOSANT ÉLECTRIQUE COMPRENANT CETTE COMPOSITION

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **31.07.2009 DE 102009035425**

(43) Veröffentlichungstag der Anmeldung:
**06.06.2012 Patentblatt 2012/23**

(73) Patentinhaber: **Epcos AG**
**81669 München (DE)**

(72) Erfinder:
• **WANG, Yongli**
  **A-8523 Frauental (AT)**
• **KOUNGA NJIWA, Alain Brice**
  **CH-8953 Dietikon (CH)**
• **HOFFMANN, Christian**
  **DE-81825 München (AT)**

(74) Vertreter: **Epping - Hermann - Fischer Patentanwaltsgesellschaft mbH**
**Schloßschmidstraße 5**
**80639 München (DE)**

(56) Entgegenhaltungen:
WO-A1-2009/116683    JP-A- 2005 047 745
JP-A- 2005 047 746    JP-A- 2005 047 748
JP-A- 2008 098 627    US-A1- 2008 237 531

• **HUANG CHIEN-CHIH ET AL: "Phase transitions and dielectric properties in Bi(Zn1/2Ti1/2)O3â BaTiO3 perovskite solid solutions", JOURNAL OF APPLIED PHYSICS, Bd. 104, Nr. 2, 30. Juli 2008 (2008-07-30) , Seiten 24117-1-24117-4, XP012117005, AMERICAN INSTITUTE OF PHYSICS. NEW YORK, US ISSN: 0021-8979, DOI: 10.1063/1.2960469**
• **CHIEN-CHIH HUANG ET AL: "Phase transitions and dielectric properties in Bi(Zn1/2Ti1/2)O3-ABO3 perovskite solid solutions", APPLICATIONS OF FERROELECTRICS, 2008. ISAF 2008. 17TH IEEE INTERNATIONAL SYMPOSIUM ON THE, 23. Februar 2008 (2008-02-23), Seiten 1-3, XP031367490, IEEE, PISCATAWAY, NJ, USA ISBN: 978-1-4244-2744-4**
• **CHIEN-CHIH HUANG ET AL: "Structure and ferroelectric properties of Bi(Zn 1/2 Ti 1/2 )O 3 -(Bi 1/2 K 1/2 )TiO 3 perovskite solid solutions", IEEE TRANSACTIONS ON ULTRASONICS, FERROELECTRICS AND FREQUENCY CONTROL, Bd. 56, Nr. 7, 1. Juli 2009 (2009-07-01), Seiten 1304-1308, XP011269897, IEEE, US ISSN: 0885-3010**
• **WANG L ET AL: "Dielectric and Piezoelectric Properties of lead-free BaTiO3-Bi(Zn0.5Ti0.5)O3 and (Bi0,5Na0,5)TiO3-Bi(Zn0,5Ti0,5)o3 Ceramics", FERROELECTRICS,, Bd. 380, 1. Januar 2009 (2009-01-01), Seiten 177-182, XP009139850, ISSN: 0015-0193**

• JÜRGEN RÖDEL ET AL.: "Perspective on the development of lead-free Piezoceramics", J. AM. CERAM. SOC., Bd. 92, Nr. 6, Juni 2009 (2009-06), Seiten 1153-1177, XP002604821,

• DATABASE WPI Week 200969 Thomson Scientific, London, GB; AN 2009-P02970 XP002604822, -& CN 101 531 510 A (UNIV WUHAN TECHNOLOGY) 16. September 2009 (2009-09-16)

**Beschreibung**

Die Beschränkung der Verwendung bestimmter gefährlicher Stoffe in Elektro- und Elektronikgeräten (RoHS - Restriction of the use of hazardous substances) wurde in einer Reihe von Gesetzgebungsverfahren und Richtlinien der Europäischen Union (EU) (z.B. Marketing of Products Package, RoHs, EuP etc.) als Beitrag zu dem Schutz der menschlichen Gesundheit und einer umweltfreundlichen Wiedergewinnung und Entsorgung von Elektro- und Elektronikalt- bzw. Schrottgeräten (WEEE - waste electrical and electronic equipment) ernsthaft in Betracht gezogen. Der letzte Vorschlag zu RoHS (Dez. 2008) legt ein strengeres Verbot von gefährlichen Substanzen für eine größere Palette von Anwendungen fest. Insbesondere bei medizinischen Vorrichtungen und Überwachungs- und Kontrollinstrumenten ist nach dem 1. Januar 2014 die Verwendung von Blei (mehr als 0,1 Gew.-%) in Elektronikkeramikteilen nicht länger von diesem Verbot ausgenommen. Bisher weisen jedoch die meisten der piezoelektrischen Hochleistungseinrichtungen (Sensoren, Aktuatoren, Resonatoren usw.) einen bleihaltigen Keramikteil auf. Die piezoelektrische Zusammensetzung basiert in der Regel auf der festen Lösung aus Bleizirkonattitanat (PZT) und befindet sich in der Nähe der morphotropen Phasengrenze (MPB) zwischen Bleititanat ($PbTiO_3$) und Bleizirkonat ($PbZrO_3$). Das toxische Element Blei (Pb) weist in diesen Materialien einen Gehalt von mehr als 60 Gew.-% auf und führt somit zu ernsthaften Umweltproblemen sowohl bei der Herstellung als auch bei der Nachbehandlung von betroffenen WEEEs.

Auf der ganzen Welt sind insbesondere in den letzten 10 Jahren zahlreiche Untersuchungen durchgeführt worden, um umweltfreundliche Ersatzstoffe für PZT zu finden. Leider wurde bisher noch kein wirklich bleifreies Material entwickelt, das PZT sowohl hinsichtlich technischer Leistung als auch hinsichtlich der Produktionskosten vollständig ersetzen kann. Optimierte Zusammensetzungen/Strukturen/Techniken haben zu einigen vergleichbaren piezoelektrischen Eigenschaften geführt, die spezifischen Anwendungen entsprechen, bei denen eine große elektrisch erzeugte Verformung (electro-strain) kein wesentliches Problem darstellt. Materialien, über die berichtet wurde und die auf Aktoranwendungen abzielen, weisen jedoch üblicherweise eine niedrigere resultierende elektrisch erzeugte Verformung (electrostrain response) im Vergleich zu der von weichem PZT auf.

Mit dem Fortschritt der Materialwissenschaft und des Technikwesens sind in den letzten beiden Jahrzehnten die piezoelektrischen Eigenschaften von umweltfreundlichen piezoelektrischen Keramikmaterialien stark verbessert worden durch Optimieren von Zusammensetzung, Mikrostruktur und die Verarbeitung betreffenden Parametern. Drei wichtige Perowskit-Familien, nämlich Bariumtitanat ($BaTiO_3$ - BT), Kalium-Natrium-Niobat ($K_{0,5}Na_{0,5}NbO_3$ - KNN) und Bismut-Natrium-Titanat ($Bi_{0,5}Na_{0,5}TiO_3$ - BNT) sind intensiv untersucht worden.

Bariumtitanat ist eines der bestbekannten Ferroelektrika, und Erfolge beim Verbessern seiner piezoelektrischen Leistung sind größtenteils dadurch erreicht worden, dass die ferroelektrische/ferroelastische Domänen-Konfigurationen eingestellt wurden:

a) durch Herstellen von speziell orientierten Keramiken oder Einkristallen kann der anisotrope Effekt der intrinsischen piezoelektrischen Eigenschaften verwendet werden (maximaler $d_{33}$-Wert von 203pC/N);
b) durch spezielle Polungsbehandlung auf Einkristallen oder durch Verwenden von fortgeschrittener Sinterungstechnologie können die von 180° verschiedenen Domänen bis auf Submikrometerskala verfeinert werden und der extrinsische Beitrag ihrer Grenzen auf den Piezoeffekt kann stark verbessert werden (maximaler $d_{33}$-Wert von 500pC/N);
c) unter Verwendung "zufälliger" Felddefekte (z.B. Acceptorsubstitutionen gepaart mit Sauerstoffvakanzen) kann der Kristall oder die Keramik durch Anlegen und Entfernen eines elektrischen Feldes vollständig gepolt und erneut entpolt werden. Durch vollständig reversible Domänenumschaltung wird somit eine ultrahohe elektrisch erzeugte Verformung verursacht. Begrenzt durch die relativ niedrige Curie-Temperatur $T_c$ (~130°C) ist der Einsatz dieser Materialfamilie jedoch von Hochleistungsaktuatoren fast ausgeschlossen.

Kalium-Natrium-Niobat ($K_{0,5}Na_{0,5}NbO_3$) ist eine Zusammensetzung nahe der MPB zwischen Kaliumniobat und Natriumniobat und weist eine hohe $T_c$ von über 400°C auf, doch wurde seine Anwendung durch die schlechte Sinterbarkeit für eine lange Zeit stark begrenzt. Jüngst stellte sich heraus, dass durch Einführen von Li auf einem A-Platz und Ta und/oder Sb auf einem B-Platz des KNN-Gitters die polymorphe Phasengrenze zwischen tetragonalen und orthorhombischen Phasen so verschoben werden kann, dass sie in die Nähe der Raumtemperatur liegt; mit entsprechenden Sinterhilfen wird die Sinterfähigkeit stark verbessert und die piezoelektrischen Eigenschaften stark angehoben (maximaler $S_{33}/E_{33}$-Wert von 300 bzw. 750 pm/V für Zufalls- oder orientierte Keramiken - Y. Saito et al., "Lead-Free Piezoceramics", Nature, 432 [4] 84-7 (2004)).

Sogar mit optimierten Zusammensetzungen und Verarbeitungsbedingungen sind diese verbesserten piezoelektrischen Eigenschaften von KNN-basierten Keramiken viel niedriger als bei typischem weichem PZT, und ihre Stabilität gegenüber Temperaturwechselspiel verschlechtert sich aufgrund des Übergangs orthorhombische/tetragonale Phase. Gleichzeitig wurde eine Verarbeitungsroutine für texturierte Keramik entwickelt, um die Gitteranisotropie auszunutzen. Die texturierten Keramiken besitzen eine viel bessere piezoelektrische Leistung (die sich mit weichem PZT vergleichen lässt), aber die komplizierten Verarbeitungsprozeduren und die erhöhten Kosten verhindern in der Praxis ihre Verwendung in Aktuatoren.

Untersuchungen zu Bismut-Natrium-Titanat- $(Bi_{0,5}Na_{0,5}TiO_3\text{-})$ Keramiken wurden darauf fokussiert, MPB-Zusammensetzungen mit anderen Perowskiten wie $BaTiO_3$, $Bi_{0,5}K_{0,5}TiO_3$, $K_{0,5}Na_{0,5}NbO_3$ usw. zu finden. Es wurden verbesserte piezoelektrische Eigenschaften erzielt (maximaler $d_{33}$-Wert von 328 pC/N), doch liegt die beste Antwort auf die elektrisch erzeugte Verformung immer noch weit unter der von weichem PZT. Außerdem besitzen BNT-basierte Materialien üblicherweise eine niedrige Entpolungstemperatur $T_d$, oberhalb derer die Polarisation und/oder Piezoelektrizität aufgrund des Übergangs ferroelektrische/antiferroelektrische Phase verschwinden. In der Regel liegt $T_d$ im Bereich von 100 bis 250°C und begrenzt den Einsatz von ferroelektrischen Keramiken auf BNT-Basis in modernen Aktuatoren stark. Es wurden auch Texturierungsprozesse untersucht, doch ist die Verbesserung sogar unter Nichtbeachtung der höheren Kosten nicht nennenswert (maximaler $S_{33}/E_{33}$-Wert von 370 pm/V) .

Jüngst wurde berichtet, dass bei entsprechend modifizierten BNT-Materialien $T_d$ auf einen Wert unterhalb der Raumtemperatur verschoben werden kann (S.T. Zhang et al., "Giant strain in lead-free piezoceramics Bi0.5Na0.5TiO3-BaTiO3-K0.5Na0.5NbO3 (BNT-BT-KNN)-system", Applied Physics Letters91, 112906(2007)). Bei diesen Zusammensetzungen kann aufgrund des durch das elektrische Feld induzierten ferroelektrischen Phasenübergangs eine ultrahohe Verformung erzielt werden. Die effektive piezoelektrische Konstante ($S_{max}/E_{max}$) kann vergleichbar sein mit (bei Keramiken maximaler $S_{33}/E_{33}$-Wert von 690 pm/V) oder sogar noch höher liegen als bei(bei Einkristallen maximaler $S_{33}/E_{33}$-Wert von über 2000 pm/V) einigen weichen PZT-Keramiken. Weiterhin ist die Entpolungstemperatur nicht länger eine praktische Grenze, da hierbei die Piezoelektrizität keine Notwendigkeit für die starke Verformung ist.

JP 2005-047748 A offenbart piezoelektrische Keramikzusammensetzungen umfassend eine erste Verbindung der Formel $(Na_{0,5}Bi_{0,5})_{S1}TiO_3$, worin S1 das A/B-Verhältnis angibt, das im Fall einer stöchiometrischen Zusammensetzung 1 beträgt, eine zweite Verbindung der Formel $(K_{0,5}Bi_{0,5})_{T1}TiO_3$, worin T1 das A/B-Verhältnis, das im Fall der stöchiometrischen Zusammensetzung 1 beträgt, angibt, und eine dritte Verbindung der Formel $Bi_u(M1_{0,5}M2_{0,5})O_3$, worin M1 mindestens eine Sorte von zweiwertigen Metallelementen der Gruppe, die aus Magnesium, Eisen, Kobalt, Kupfer und Zink besteht, angibt und M2 mindestens eine Sorte von vierwertigen Metallelementen der Gruppe bestehend aus Titan, Zirkon und Zinn angibt. u beträgt 1 im Falle der stöchiometrischen Zusammensetzung. Beispielsweise ist die erste Verbindung $(Na_{0,5}Bi_{0,5})_{0,99}TiO_3$, die zweite Verbindung $(K_{0,5}Bi_{0,5})_{0,99}TiO_3$ und die dritte Verbindung $Bi(Fe_{0,5}Ti_{0,5})O_3$. Die ersten beiden Verbindungen besitzen eine Perowskitstruktur.

JP 2005-047746 A entspricht in seinem Offenbarungsgehalt weitestgehend JP 2005-047748 A, wobei die dritte Verbindung enger definiert ist, da als vierwertiges Metallelement nur Zirkon und Zinn, aber nicht Titan zugelassen ist.

US 2008/237531 A1 offenbart piezoelektrische Keramikzusammensetzungen umfassend $(Bi_{0,5}(Na,K)_{0,5})TiO_3)$ und $Bi(Me_{0,5},E_{0,5})O_3$, wobei Me = Mn und E = Ti, Ze oder umfassend drei Komponenten: $(Bi_{0,5}(Na,K)_{0,5})TiO_3)$, $BaTiO_3$ und $Bi(Mn_{0,5},Ti_{0,5})O_3$.

JP 2008-098627 A offenbart piezoelektrische Keramikzusammensetzungen umfassend $(Bi,Ba)(M,Ti)O_3$, worin M ein Atom eines Elementes oder eine Kombination aus zwei oder mehr solcher Atome umfassend Mg oder Zn darstellt. Chien-Chih Huang et al.: "Phase transitions and dielectric properties in Bi(Zn1/2Ti1/2)O3â BaTiO3 perovskite solid solutions", JOURNAL OF APPLIED PHYSICS, Bd. 104, Nr. 2, 30. Juli 2008 (2008-07-30), Seiten 24117-1-24117-4, XP012117005, AMERICAN INSTITUTE OF PHYSICS. NEW YORK; Chien-Chih Huang et al.: "Phase transitions and dielectric properties in Bi(Zn1/2Ti1/2)O3-ABO3 perovskite solid solutions", APPLICATIONS OF FERROELECTRICS, 2008. ISAF 2008. 17TH IEEE INTERNATIONAL SYMPOSIUM ON THE, 23. Februar 2008 (2008-02-23), Seiten 1-3; Chien-Chih Huang et al.: "Structure and ferroelectric properties of Bi(Zn1/2Ti1/2)03-(Bi1/2K1/2)TiO3 perovskite solid solutions", IEEE TRANSACTIONS ON ULTRASONICS, FERROELECTRICS AND FREQUENCY CONTROL, Bd. 56, Nr. 7, 1. Juli 2009 (2009-07-01), Seiten 1304-1308; und Wang L. et al: "Dielectric and Piezoelectric Properties of lead-free BaTiO3-Bi(Zn0.5Ti0.5)O3 and (Bi0.5Na0.5)TiO3-Bi(Zn0.5Ti0.5)O3 Ceramics", FERROELECTRICS, Bd. 380, 1. Januar 2009 (2009-01-01), Seiten 177-182 offenbaren jeweils Untersuchungen von binären BT-BZT-, BZT-BNT- und BZT-BKT-Systemen (vgl. Titel der jeweiligen Druckschriften). JP 2005-047745 offenbart eine piezoelektrische Keramik mit verbesserten piezoelektrischen Eigenschaften. Die piezoelektrische Keramik enthält, eine dritte Verbindung, die Bi, mindestens eine Art von zweiwertigem Metallelement, ausgewählt aus der Gruppe bestehend aus Mg, Fe, Co, Ni, Cu und Zn, mindestens eine Art von vierwertigem Metallelement, ausgewählt aus der Gruppe bestehend aus Ti, Zr und Sn, und Sauerstoff enthält, zusätzlich zu einer ersten Verbindung mit einer rhomboedrischen Perowskit-Struktur und eine zweite Verbindung, die eine tetragonale Perowskit-Struktur und die Bariumtitanat. Diese Komponenten können als eine feste Lösung vorliegen. Es ist bevorzugt, dass, wenn das molare Zusammensetzungsverhältnisse der ersten Verbindung, der zweiten Verbindung und der dritten Verbindung werden als x-, y-bzw. z, x, y und z bezeichnet sind, folgende Bedingungen erfüllt sind: $x + y + z = 1$ und $0,35 \leq x \leq 0,99$, $0 < y \leq 0,55$ und $0 < z \leq 0,1$. Beispiele für die drei Verbindungen sind: erste Verbindung: $(Na_{0,5}Bi_{0,5})TiO_3$; zweite Verbindung: $BaTiO_3$ oder $(K_{0,5}Bi_{0,5})TiO_3$; dritte Verbindung 3: $Bi(M1_{0,5}M2_{0,5})O_3$ mit M1 = Mg, Fe, Co, Ni, Cu oder Zn; und M2 = Ti, Zr oder Sn).

Eine Aufgabe der vorliegenden Erfindung besteht deshalb in der Bereitstellung von bleifreien Keramikzusammensetzungen, die eine hohe Antwort auf die resultierende elektrisch erzeugte Verformung zeigen.

Die vorliegende Erfindung betrifft eine Auswahl bleifreier Keramikmaterialien, die eine große elektrisch erzeugte Verformung bereitstellen können, die für Aktoranwendungen erwünscht ist. Insbesondere werden eine Reihe bleifreie Zusammensetzungen vorgestellt, die, wenn sie einem adäquaten externen elektrischen Feld ausgesetzt werden, eine große resultierende Verformung aufweisen. Die große elektrisch erzeugte Verformung entsteht im Allgemeinen im Wesentlichen aus einem durch ein elektrisches Feld induzierten Phasenübergang, und die Größe der effektiven piezoelektrischen Konstanten $S_{max}/E_{max}$ ist vergleichbar mit einigen weichen PZT, die in kommerziellen piezoelektrischen Aktuatoren verwendet werden.

Im Allgemeinen enthält die bleifreie Zusammensetzung mehr als 97 Gew.-% eines Matrixmaterials und gegebenenfalls eine geringe Menge Additiv von unter 3 Gew.-%.

Vorstehende Aufgabe wird erfindungsgemäß durch die Bereitstellung einer piezoelektrischen Keramikzusammensetzung nach Anspruch 1, eines Verfahrens zur Herstellung der Zusammensetzung nach Anspruch 7 und ein elektrisches Bauelement nach Anspruch 11 erreicht. Bevorzugte Ausführungsformen werden in den abhängigen Ansprüchen dargestellt.

Die kleine Menge an Additiv enthält Nicht-Perowskit-Oxide, beispielsweise MnO, CuO, ZnO oder eine Kombination von ihnen. Diese Additive sind nicht auf die Form einfacher Oxiden begrenzt. Diese Oxide können unterschiedliche Oxidierungswertigkeiten aufweisen und können aus den entsprechenden Carbonaten, Nitraten, Hydroxiden usw. erhalten werden.

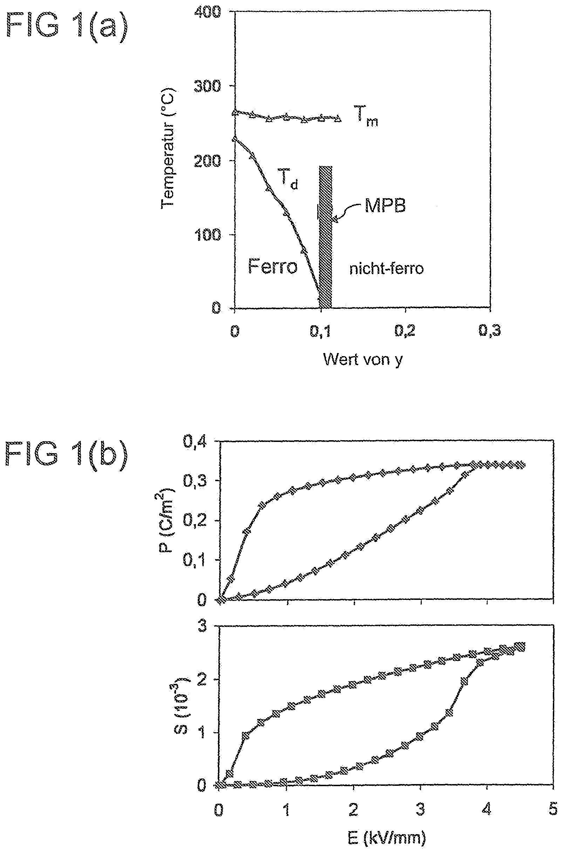

Die Anteile der drei Matrixkomponenten werden so eingestellt, dass zwischen einer ferroelektrischen Phase und einer pseudokubischen nicht-ferroelektrischen Phase eine morphotrope Phasengrenze (MPB) entsteht [siehe Figur 1 (a)]. Pseudokubische Zusammensetzungen in der Nähe der Phasengrenze erfahren bei einem bestimmten elektrischen Feld einen strukturellen Übergang in die ferroelektrische Phase und, wenn das elektrische Feld entfernt wird, einen entgegengesetzten Übergang zurück zur pseudokubischen Phase [siehe Figur 1 (b)]. Die damit einhergehende Verformung bringt eine große elektrisch erzeugte Verformung mit sich, die vergleichbar ist mit der von typischen, in fortgeschrittenen Aktuatoren verwendeten weichen PZT-Keramiken oder sogar noch höher ist. Der maximale $S_{max}/E_{max}$-Wert über 800 pm/V kann erhalten werden, indem die Zusammensetzung und die Verarbeitungsbedingungen optimiert werden und ein entsprechendes Ansteuersignal verwendet wird.

Ein Additiv wird insbesondere dann zugesetzt, wenn eine Absenkung der Sintertemperatur oder eine Verdichtung gewünscht ist. Der Gehalt des Additivs wird bevorzugt so eingestellt, dass die Sintertemperatur gesenkt und die Verdichtung gefördert wird, ohne dass die elektromechanischen Eigenschaften der Matrixzusammensetzungen nennenswert beeinflusst werden. Qualitativ hochwertige bleifreie Keramiken mit einer hohen elektrischen Belastung können mit einer Sintertemperatur von nur 1000°C erreicht werden.

Gemäß einer Ausführungsform kann die Hauptzusammensetzung angegeben werden als k $(Bi_{0,5}A_{0,5})EO_3$ - 1 $BaEO_3$ - m $Bi(Me_{0,5}E_{0,5})O_3$, wobei A beispielsweise für eines oder zwei der Elemente Na und K steht, Me beispielsweise für eines oder zwei der Elemente Mg und Zn steht, E für Ti oder Zr steht, $0 \leq k \leq 0,96$, $0 \leq 1 \leq 0,96$ und k+l+m=1. Metalloxidadditive ($\leq$3 Gew.-%), beispielsweise MnO, ZnO, CuO oder die entsprechenden Carbonate, Nitrate, Hydrate oder eine Kombination von ihnen, können enthalten sein, um das Sinterverhalten zu beeinflussen.

Die große elektrisch erzeugte Verformung wird üblicherweise erzielt, wenn obenerwähnte Keramiken einem bestimmten elektrischen Feld von nicht weniger als $E_{th1}$ ausgesetzt werden. Hierbei ist $E_{th1}$ die Schwellwertfeldstärke, bei der ein struktureller Phasenübergang stattfindet, der zu einer großen Verformung führt.

Im Vergleich zu PZT und anderen piezoelektrischen Keramiken erfordern die Materialien der vorliegenden Erfindung üblicherweise keine Polungsprozedur, bevor sie verwendet werden können. Diese Eigenschaft führt zu einem vereinfachten Prozess und somit niedrigeren Produktionskosten und weniger mit der Fabrikation verbundenen Defekten für entsprechende Aktuatoreinrichtungen.

Weiterhin besitzen gegenwärtig verwendete Materialien bei ihrer Verwendung keine Polaritätseinschränkung. Sie können mit einer unipolaren oder bipolaren Spannung oder einer beliebigen Kombination aus beiden angesteuert werden. Die Ansteuerbedingungen sind somit flexibler. Weiterhin ist eine remanente Polarisation für die in der vorliegenden Erfindung offenbarten Materialien nicht nötig, um eine große Belastung zu erhalten. Die hohe Verformung ist über ein großes Temperaturintervall gewährleistet und wird durch keine kritischen Temperaturen wie Curie-Temperatur oder Entpolungstemperatur begrenzt. Im Vergleich zu anderen bleifreien Materialien mit hoher Verformung erfordern die in der vorliegenden Erfindung offenbarten Zusammensetzungen in der Regel weder eine texturierte Struktur noch eine spezielle Sintertechnik. Sie können alle ohne weiteres unter Verwendung eines herkömmlichen Festkörperreaktionsverfahrens bei Umgebungsdruck bei moderater Temperatur, insbesondere bei 1000-1200°C, hergestellt werden. Die Produktionskosten werden somit erheblich gesenkt.

Weitere Merkmale, Vorteile und Zweckmäßigkeiten ergeben sich aus der folgenden Beschreibung der Beispiele und Ausführungsbeispiele.

Fig. 1 zeigt die MPB zwischen einer ferroelektrischen Phase und einer nicht-ferroelektrischen Phase (a) und die hohe, auf einen feldinduzierten Phasenübergang zurückzuführende elektrisch erzeugte Verformung für eine nichtferroelektrische Zusammensetzung in der Nähe von MPB (b).

Figur (a) zeigt dabei ein typisches Phasendiagramm eines (1-y)[(1-x)BNT-xBT]-yBMT-Systems, wobei hierin x auf 0,20 festgelegt ist und y von 0 bis 0,14 variiert wird. Figur (b) zeigt typische elektromechanisches Eigenschaften gemäß der vorliegenden Erfindung, wobei x=0,20 und y=0,11.

Fig. 2 zeigt XRD Muster von Zusammensetzungen des (1-y)[0,80BNT-0,20BT]-yBMT-Systems (a) und entsprechende Gitterkonstanten beim Queren der MPB (b).

Fig. 3 zeigt P-E- (a) und S-E- (b) Kurven der (1-y)[0,80BNT-0,20BT]-yBMT-Zusammensetzungen in der Nähe der MPB.

Fig. 4 zeigt eine resultierende elektrisch erzeugte Verformung von 0,89[0,80BNT-0,20BT]-0,11BMT, wobei die beiden charakteristischen Schwellwertfelder $E_{th1}$ und $E_{th2}$ markiert sind (a), und die effektive piezoelektrische Konstanten $d_{33}^*$ in Abhängigkeit vom elektrischen Feld, (b).

Fig. 5 zeigt die Variation der Schwellwertfelder $E_{th1}$ und $E_{th2}$, (a), und die effektive piezoelektrische Konstante $d_{33}^*$, (b), als Funktion des BMT-Gehalts im (1-y)[0,80BNT-0,20BT]-yBMT-System.

Fig. 6 zeigt XRD-Muster von Zusammensetzungen des (1-y)[0,95BNT-0,05BT]-yBMT-Systems (a) und die resultierende elektrisch erzeugte Verformung der pseudokubischen Zusammensetzung in der Nähe der MPB (b).

Fig. 7 zeigt XRD-Muster von Zusammensetzungen des (1-y)[0,93BNT-0,07BT]-yBMT-Systems (a) und die resultierende elektrisch erzeugte Verformung der pseudokubischen Zusammensetzung in der Nähe der MPB (b).

Fig. 8 zeigt XRD-Muster von Zusammensetzungen des (1-y)[0,80BKT-0,20BT]-yBMT-Systems (a) und die resultierende elektrische Verformung der pseudokubischen Zusammensetzung in der Nähe der MPB (b).

Fig. 9 zeigt XRD-Muster von Zusammensetzungen des (1-y)[0,80BNT-0,20BT]-yBZT-Systems (a) und die resultierende elektrisch erzeugte Verformung der pseudokubischen Zusammensetzung in der Nähe der MPB (b).

Fig. 10 zeigt die Verdichtungskurve der undotierten und mit Oxiden dotierten BNT-BT-BMT-Keramiken.

Fig. 11 zeigt die resultierende elektrisch erzeugte Verformung von mit CuO (a), ZnO (b) und $Mn_2O_3$ (c) dotierten BNT-BT-BMT-Keramiken.

[Beispiel 1] :

Bei diesem Beispiel wird eine Reihe von MPBs zwischen einer tetragonalen ferroelektrischen Phase und einer pseudokubischen nicht-ferroelektrischen Phase innerhalb des ternären Systems ausgebildet, das durch $(Bi_{0,5}Na_{0,5})TiO_3$, $BaTiO_3$ und $Bi(Mg_{0,5}Ti_{0,5})O_3$, d.h. (BNT-BT-BMT), gebildet wird,. Die typische Zusammensetzung kann formuliert werden als (1-y)[(1-x)BNT-xBT]-yBMT, wobei 0,07<x<1 und 0,04<y<0,14. Die A/B-Verhältnisse (bezüglich der Perowskit-$ABO_3$-Formel) in diesem Beispiel werden alle als Einheit kontrolliert und es wird kein Additiv hinzugefügt. Die tetragonale ferroelektrische Phase wird durch die feste Lösung zwischen BNT und BT ausgebildet, und ihre Tetragonalität nimmt mit zunehmendem BMT-Gehalt allmählich ab und ist schließlich bei der MPB verschwunden.

Als Ausgangsmaterialien werden kommerziell erhältliche hochreine (>99,8%) Pulver von $Bi_2O_3$, $Na_2CO_3$, $BaCO_3$, $TiO_2$ und MgO verwendet. Es wird eine herkömmliche Festkörperreaktions-Routine verwandt, um die betreffenden Keramiken herzustellen. Die Rohpartikel werden gemäß der Stöchiometrie der Perowskit-$ABO_3$-Formel gewogen und dann gemischt und mit einer Kugelmühle gemahlen, wobei Yttrium-stabilisierte $ZrO_2$-Kugeln als das Mahlmedium und dehydriertes Ethanol als das Mahlmittel verwendet werden. Die gemahlene Aufschlämmung wird dann in einem Ofen bei 60°C getrocknet. Das getrocknete Pulver wird gesiebt und bei Temperaturen von 750°C bis 900°C 2-4 h für die Ausbildung einer homogenen Perowskit-Struktur kalziniert. Das gebrannte Pulver wird wieder in einer Kugelmühle gemahlen, um die Partikelgröße zu verfeinern (bevorzugt bis herunter zu -0,7 μm). Das Pulver wird wie erhalten mit einer entsprechenden Menge an PVB-Bindemittel getrocknet und granuliert und wird dann zu Pellets mit einem Durchmesser von 15,6 mm und einer Dicke von 1,5 mm gepresst. Die ungesinterten Scheiben werden 2 h lang bei 450°C entbindert und dann 1-2 h lang bei hohen Temperaturen im Bereich von 1000 bis 1200°C gesintert. Die beiden Hauptseiten der verdichteten Presslinge werden mit Silberpaste beschichtet, um Parallelplattenkondensatoren zu erzeugen. Dielektrische Eigenschaften werden mit einer hochpräzisen LCR-Brücke als Funktion von Temperatur und Frequenz gemessen.

Die Längenänderung der Keramiken wird als Funktion des elektrischen Feldes mit einem computergesteuerten System aus Hochspannungsverstärker und linearem variablem Differentialtransformator (LVDT) gemessen. Eine Dreieckswellenform und eine niedrige Frequenz von 0,1 Hz werden als das Ansteuersignal verwendet, wobei dessen Amplitude von 1 kV/mm bis 7 kV/mm variiert.

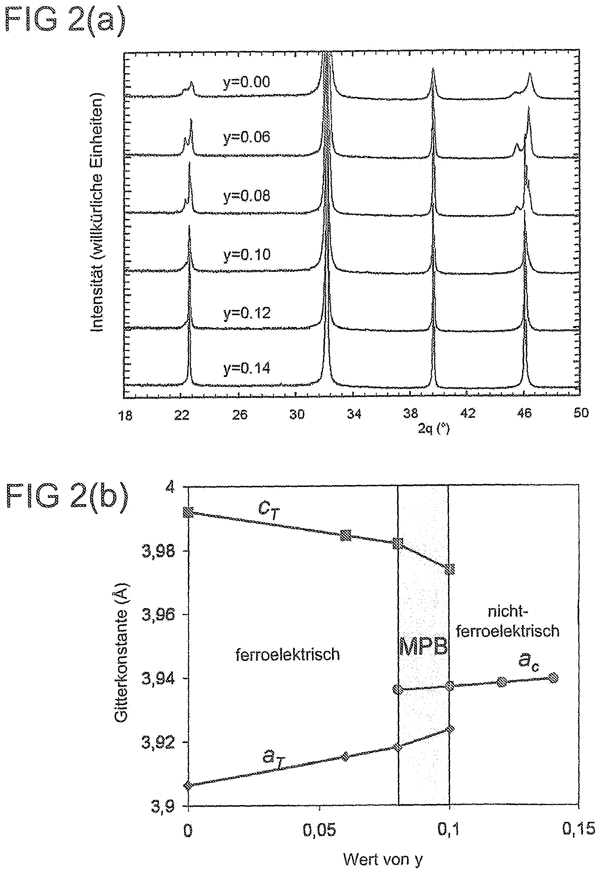

Um die MPB zwischen der tetragonalen ferroelektrischen Phase und der pseudokubischen nicht-ferroelektrischen Phase eindeutig zu erklären, sind in Figuren 2 (a) und (b) die XRD-Muster und Gitterkonstanten als Funktion des y-Werts (der oben gezeigten typischen Zusammensetzung) gezeigt, wobei x (zum Beispiel) als 0,2 festgelegt ist. Mit der Zunahme an BMT-Gehalt nimmt die Tetragonalität der ferroelektrischen Phase ab und verschwindet schließlich bei y>0,10. Die Position der MPB wird deshalb als die Zusammensetzung oder das Zusammensetzungsgebiet bestimmt, wo die tetragonale Phase und die pseudokubische Phase coexistieren.

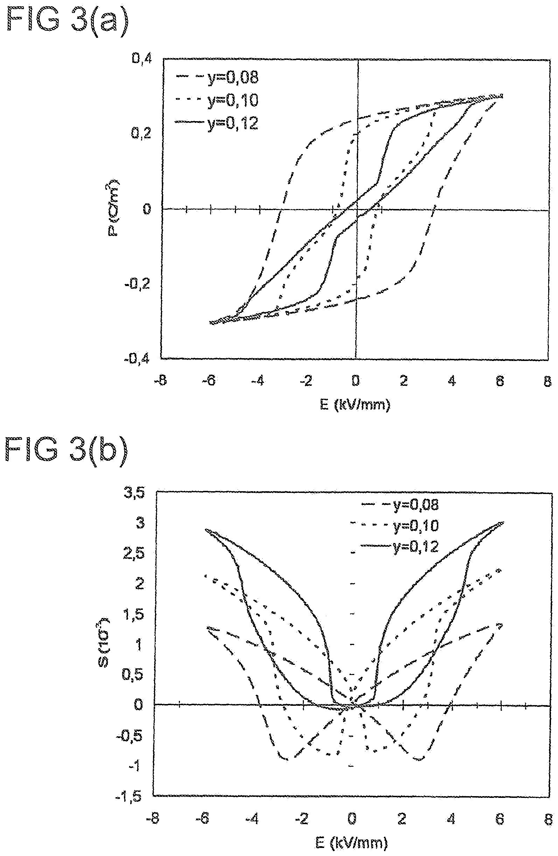

Zusammensetzungen in der Nähe der MPB weisen sehr unterschiedliche dielektrische und elektromechanische Eigenschaften auf, je nach der Struktur, die sie besitzen. Auf der tetragonalen Seite, zum Beispiel y=0,09, verhalten sich die Keramiken wie ein typisches ferroelektrisches Material, durch die quadratische P-E-Hystereseschleife und die schmetterlingsartige Verformung-E-Feld-Kurve gezeigt. Ein hoher piezoelektrischer Koeffizient kann mit einem Berlincourt-$d_{33}$-Messgerätaufbau direkt gemessen werden. Im Gegensatz dazu zeigen auf der pseudokubischen Seite, zum Beispiel y=0,11, die Keramiken bei einem kleinen elektrischen Feld paraelektrische Eigenschaften und ändern sich bei stärkerem elektrischem Feld zur ferroelektrischen Phase. Wenn das externe elektrische Feld entfernt wird, wechselt die Keramik zurück in den nicht-ferroelektrischen Zustand, wie durch die gequetschte P-E-Schleife und die remanente Verformung von 0 in der S-E-Kurve gezeigt wird. Für die MPB-Zusammensetzung zeigt die Feldabhängigkeit der Polarisation und der Verformung eine Zwischenform zwischen den beiden zuvor erwähnten Fällen. Die Figuren 3 (a) und (b) zeigen eine repräsentative P-E- und S-E-Kurven von Zusammensetzungen in der Nähe der MPB.

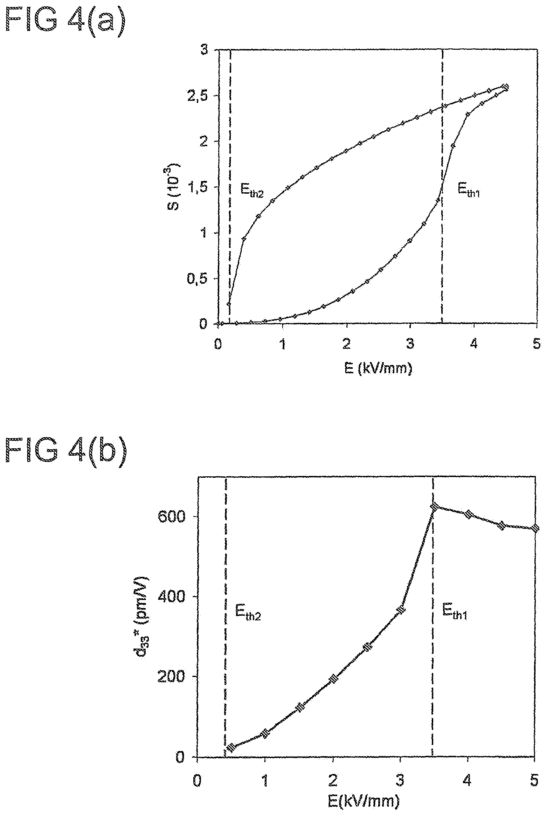

In der Nähe der MPB kann durch den durch das elektrische Feld induzierten Phasenübergang eine große Verformung in pseudokubischen Zusammensetzungen erhalten werden. Dieser Übergang ist jedoch ein Übergang erster Ordnung und kann nicht auf kontinuierliche und anhysteretische Weise stattfinden. Ein erstes Schwellwertfeld $E_{th1}$ [siehe Fig. 4 (a)] muss überschritten werden, um den ferroelektrischen Phasenübergang zu induzieren. Gleichzeitig muss ein zweites Schwellwertfeld $E_{th2}$ größer als null sein, um den nicht-ferroelektrischen Zustand wiederherzustellen, wenn das elektrische Feld entfernt wird. Eine derartige Notwendigkeit ist in Figuren 4 (a) und (b) zu sehen, wobei die maximale Verformung und die effektive piezoelektrische Konstante $d_{33}^* = Smax/Emax$ abrupt ansteigen, wenn $E_{max}$ größer als $E_{th1}$ ist. Mit der weiteren Zunahme von $E_{max}$ werden Verformung und Polarisation im Allgemeinen gesättigt und $d_{33}^*$ nimmt allmählich ab.

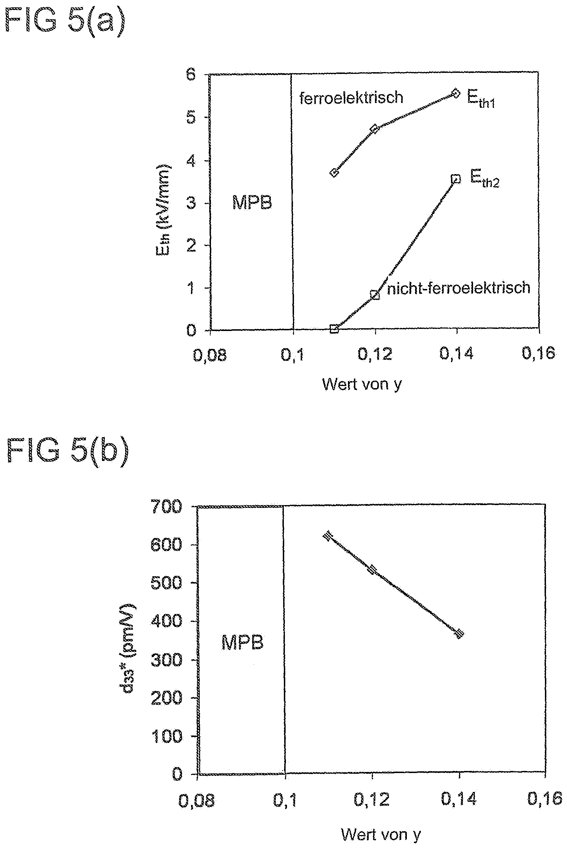

Die Größe von $E_{th1}$ und $E_{th2}$ hängt stark von der Zusammensetzung ab: je weiter die Zusammensetzung von der MPB entfernt ist, umso höher sind die $E_{th}$-Größen, wie in Fig. 5 (a) gezeigt. Folglich nimmt der Wert des maximalen $d_{33}^*$ mit dem Gehalt von BMT in der pseudokubischen Seite ab, wie in Fig. 5 (b) gezeigt.

Zusammengefasst kann bei einem gegebenen x-Wert die hohe elektrische Verformung erhalten werden durch 1) Einstellen des BMT-Anteils, so dass $E_{th1}>E_{ths}\geq0$, durch 2) Verwenden eines Ansteuerfelds, bei dem $E_{max}>E_{th1}$. Besonders bevorzugt weist der effektive piezoelektrische Koeffizient $d_{33}^*$ einen Maximalwert auf, wenn $E_{th2}=0$ und $E_{max}=E_{th1}$,

oder 3) durch eine Kombination aus 1) und 2).

In Tabelle I sind die Zusammensetzungen mit verschiedenen x-Werten aufgeführt, die ein hohes elektrisches Verformungsverhalten zeigen. Der höchste effektive $d_{33}^*$-Wert wird erhalten, wenn sich das Ferroelektrikum (1-x)BNT-xBT selbst nahe der MPB zwischen tetragonaler und rhomboedrischer Phase befindet, wenn nämlich x=0,07 ist.

Tabelle I: Zusammensetzungen und ihr elektromechanisches Verhalten im (1-y)[(1-x)BNT-xBT]-yBMT-System:

| Probe Nr. | x | y | Ferroelektrische Symmetrie | $S_{max}$ ($10^{-3}$) | $E_{max}$ (kV/mm) | $d_{33}^*$ (pm/V) |
|---|---|---|---|---|---|---|
| 1* | 0,05 | 0,12 | R | 3, 67 | 6, 6 | 550 |
| 2 | 0,06 | 0,06 | MPB | 4,09 | 5,0 | 820 |
| 3 | 0,07 | 0,04 | MPB | 4,00 | 5,0 | 800 |
| 4* | 0,15 | 0,09 | T | 2,39 | 3,9 | 610 |
| 5* | 0,20 | 0,11 | T | 2,17 | 3,5 | 620 |
| 6* | 0,30 | 0,11 | T | 2,26 | 3,9 | 580 |
| 7* | 0,40 | 0,08 | T | 1, 92 | 3,5 | 550 |
| 8* | 0,60 | 0,065 | T | 1,73 | 3,8 | 360 |

(fortgesetzt)

| Probe Nr. | x | y | Ferroelektrische Symmetrie | $S_{max}$ ($10^{-3}$) | $E_{max}$ (kV/mm) | $d_{33}$* (pm/V) |
|---|---|---|---|---|---|---|
| 9* | 0,80 | 0,065 | T | 1,03 | 2,1 | 490 |
| *nicht erfindungsgemäß | | | | | | |

[Beispiel 2]:

Bei diesem Beispiel wird eine Reihe von MPBs zwischen einer rhomboedrischen ferroelektrischen Phase und einer pseudokubischen nicht-ferroelektrischen Phase innerhalb des ternären Systems ausgebildet, das durch $(Bi_{0,5}Na_{0,5})TiO_3$, $BaTiO_3$ und $Bi(Mg_{0,5}Ti_{0,5})O_3$, d.h. (BNT-BT-BMT), gebildet wird.

Die rhomboedrische ferroelektrische Phase wird durch die feste Lösung zwischen BNT und BT ausgebildet, und ihre ferroelektrische Verzerrung nimmt mit zunehmendem BMT-Gehalt allmählich ab und ist schließlich bei der MPB verschwunden.

Die typische Zusammensetzung kann formuliert werden als (1-y)[(1-x)BNT-xBT]-yBMT, wobei 0<x<0,05 und 0,06<y<0,14. Die A/B-Verhältnisse (bezüglich der Perowskit-$ABO_3$-Formel) in diesem Beispiel werden alle als Einheit kontrolliert und es wird kein Additiv hinzugefügt.

Die Verarbeitung und Charakterisierung dieser Zusammensetzungen sind den in Beispiel 1 gezeigten ähnlich.

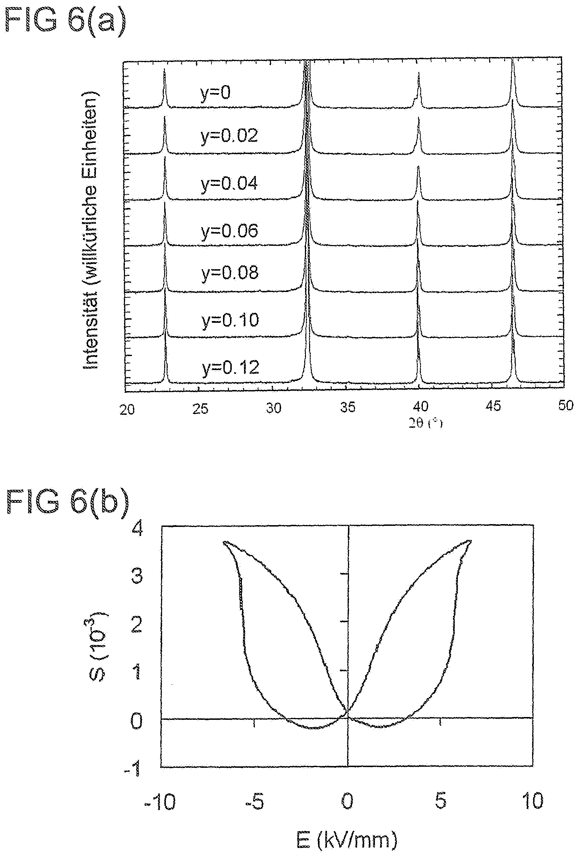

Die strukturelle Änderung von rhomboedrischer zu pseudokubischer Phase wird durch Erhöhen des BMT-Gehalts realisiert, wie in Fig. 6 (a) gezeigt. Das elektromechanische Verhalten einer typischen Zusammensetzung ist in Fig. 6 (b) gezeigt.

[Beispiel 3]:

Bei diesem Beispiel wird eine MPB zwischen einer ferroelektrischen MPB-Zusammensetzung und einer pseudokubischen nicht-ferroelektrischen Phase innerhalb des ternären Systems ausgebildet, das durch $(Bi_{0,5}Na_{0,5})TiO_3$, $BaTiO_3$ und $Bi(Mg_{0,5}Ti_{0,5})O_3$, d.h. nämlich (BNT-BT-BMT), gebildet wird.

Die ferroelektrische MPB-Zusammensetzung liegt zwischen zwei ferroelektrischen Phasen von unterschiedlicher Symmetrie, zum Beispiel tetragonaler und rhomboedrischer Phase im BNT-BT-System. Die ferroelektrische Verzerrung nimmt mit zunehmendem BMT-Gehalt langsam ab und verschwindet schließlich.

Die typische Zusammensetzung kann formuliert werden als (1-y)[(1-x)BNT-xBT]-yBMT, wobei x=0,07 und 0,06<y<0,14. Die A/B-Verhältnisse (bezüglich der Perowskit-$ABO_3$-Formel) in diesem Beispiel werden alle als Einheit kontrolliert und es wird kein Additiv hinzugefügt.

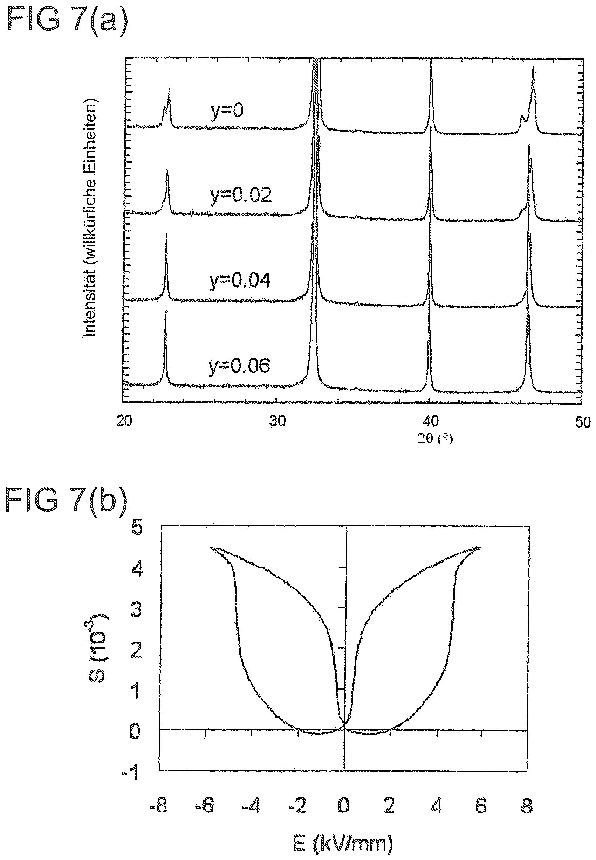

Die Verarbeitung und Charakterisierung dieser Zusammensetzungen sind den in Beispiel 1 gezeigten ähnlich. Die strukturelle Änderung von ferroelektrischer MPB zu pseudokubischer Phase wird durch zunehmenden BMT-Gehalt realisiert, wie in Fig. 7 (a) gezeigt. Das elektromechanische Verhalten einer typischen Zusammensetzung ist in Fig. 7 (b) gezeigt.

[Beispiel 4] :

Bei diesem Beispiel wird eine MPB zwischen einer tetragonalen ferroelektrischen Phase und einer pseudokubischen nicht-ferroelektrischen Phase innerhalb des ternären Systems ausgebildet, das durch $(Bi_{0,5}K_{0,5})TiO_3$, $BaTiO_3$ und $Bi(Mg_{0,5}Ti_{0,5})O_3$, d.h. (BKT-BT-BMT), gebildet wird.

Die tetragonale ferroelektrische Phase wird durch die feste Lösung zwischen BKT und BT ausgebildet, und ihre ferroelektrische Verzerrung nimmt mit zunehmendem BMT-Gehalt allmählich ab und ist schließlich bei der MPB verschwunden.

Die typische Zusammensetzung kann formuliert werden als (1-y)[(1-x)BKT-xBT]-yBMT, wobei x=0,20 und 0,09<y<0,14. Die A/B-Verhältnisse (bezüglich der Perowskit-$ABO_3$-Formel) in diesem Beispiel werden alle als Einheit kontrolliert und es wird kein Additiv hinzugefügt.

Die Verarbeitung und Charakterisierung dieser Zusammensetzungen sind den in Beispiel 1 gezeigten ähnlich.

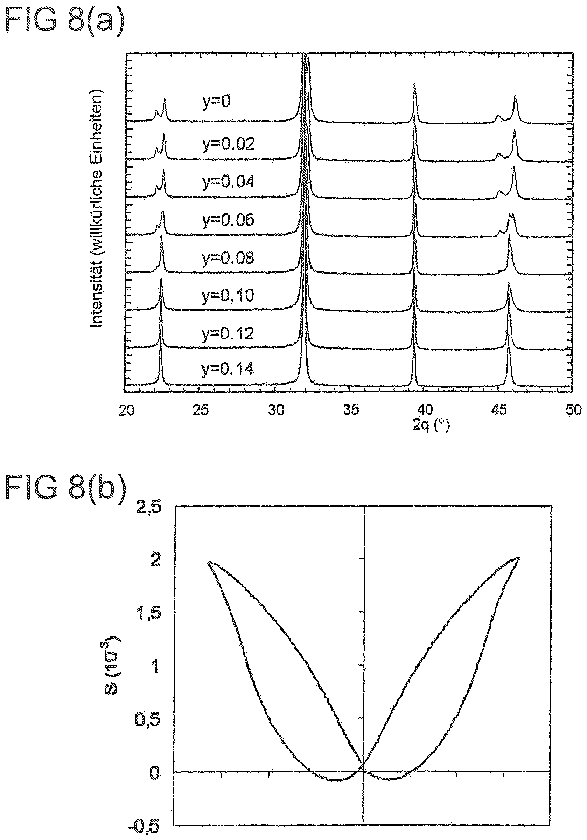

Die strukturelle Änderung von tetragonaler zu pseudokubischer Phase wird realisiert durch Erhöhen des BMT-Gehalts wie in Fig. 8 (a) gezeigt. Das elektromechanische Verhalten einer typischen Zusammensetzung ist in Fig. 8 (b) gezeigt.

[Beispiel 5]:

Bei diesem Beispiel wird eine MPB zwischen einer tetragonalen ferroelektrischen Phase und einer pseudokubischen nicht-ferroelektrischen Phase innerhalb des ternären Systems ausgebildet, das durch $(Bi_{0,5}Na_{0,5})TiO_3$, $BaTiO_3$ und $Bi(Zn_{0,5}Ti_{0,5})O_3$, d.h. (BNT-BT-BZT), gebildet wird.

Die tetragonale ferroelektrische Phase wird durch die feste Lösung zwischen BNT und BT ausgebildet, und ihre ferroelektrische Verzerrung nimmt mit zunehmendem BZT-Gehalt allmählich ab und ist schließlich bei der MPB verschwunden.

Die typische Zusammensetzung kann formuliert werden als (1-y)[(1-x)BNT-xBT]-yBZT, wobei x=0,20 und 0,10<y<0,14. Die A/B-Verhältnisse (bezüglich der Perowskit-$ABO_3$-Formel) in diesem Beispiel werden alle als Einheit kontrolliert und es wird kein Additiv wird hinzugefügt.

Die Verarbeitung und Charakterisierung dieser Zusammensetzungen sind den in Beispiel 1 gezeigten ähnlich.

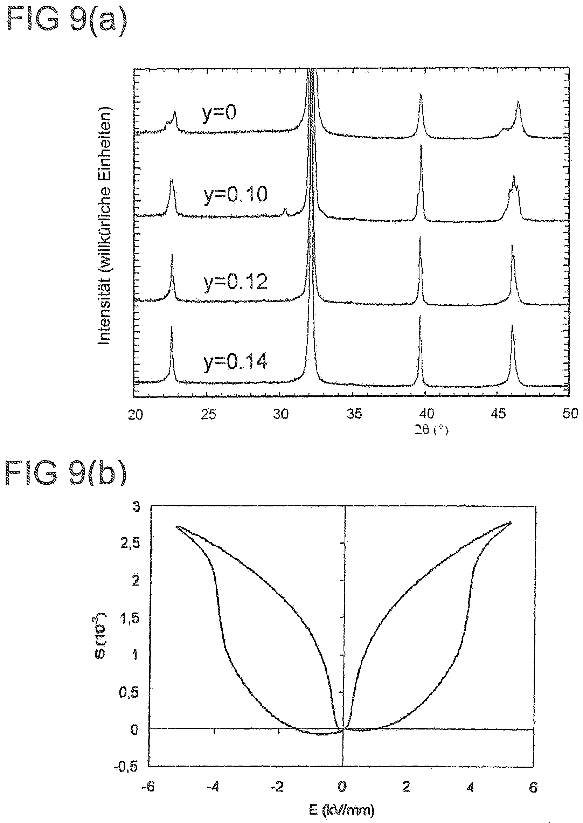

Die strukturelle Änderung von tetragonaler zu pseudokubischer Phase wird realisiert durch Erhöhen des BZT-Gehalts, wie in Fig. 9 (a) gezeigt. Das elektromechanische Verhalten einer typischen Zusammensetzung ist in Fig. 9 (b) gezeigt.

[Beispiel 6] :

Bei diesem Beispiel wird ein Matrixmaterial einer MPB-Zusammensetzung hergestellt aus $(Bi_{0,5}Na_{0,5})TiO_3$, $BaTiO_3$ und $Bi(Mg_{0,5}Ti_{0,5})O_3$, d.h. (BNT-BT-BMT). Eine kleine Menge (0,5 Gew.-%) eines Nicht-Perowskit-Additivs wird vor dem Sintern zugefügt.

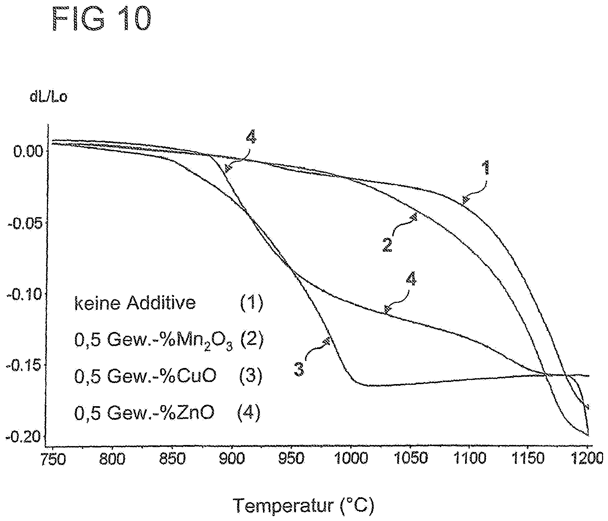

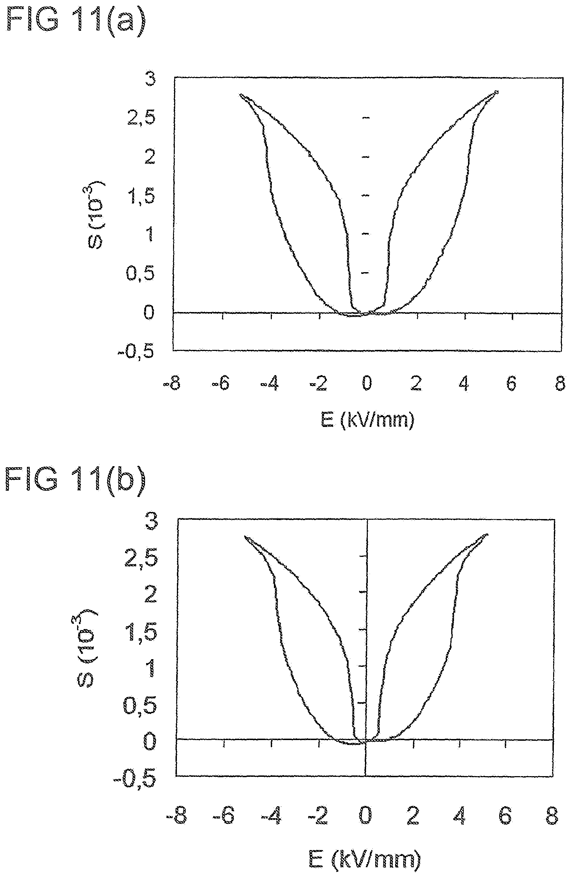

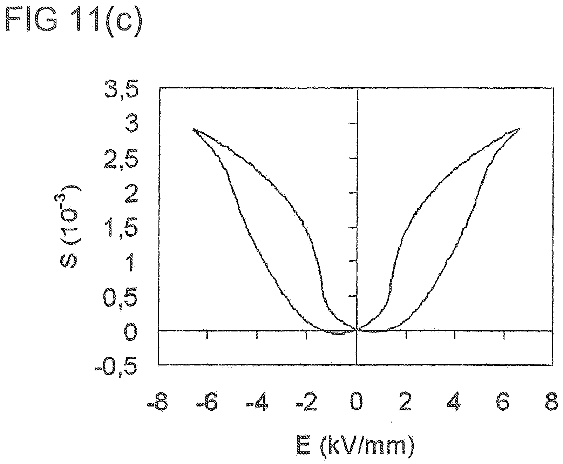

Der Gehalt der Oxidadditive wird so gewählt, dass die Verarbeitungseigenschaften verbessert werden und dass sich die elektromechanischen Eigenschaften nicht nennenswert verschlechtern. Fig. 10 zeigt die Verdichtungskurven von bleifreien Zusammensetzungen, die mit verschiedenen Oxidadditiven dotiert sind. Die Verdichtungstemperatur kann durch MnO und ZnO drastisch herabgesetzt werden. Die elektromechanischen Eigenschaften der niedriggebrannten Zusammensetzungen (1100°C) sind in Fig. 11 (a), (b) bzw. (c) gezeigt.

**Patentansprüche**

1. Piezoelektrische Keramikzusammensetzung umfassend ein Matrixmaterial umfassend mindestens drei Matrixkomponenten mit einer Perowskit-Struktur oder bestehend aus diesen Matrixkomponenten,
   wobei die erste Matrixkomponente $(Bi_{0,5}A_{0,5})EO_3$ ist,
   eine zweite Matrixkomponente $BaEO_3$ ist und
   eine dritte Matrixkomponente $Bi(Me_{0,5}E_{0,5})O_3$ ist,
   A ausgewählt ist aus einem Alkalimetall, insbesondere Natrium oder Kalium, oder einer Mischung aus Alkalimetallen;
   E unabhängig ausgewählt ist aus Titan, Zirkonium und Mischungen aus Titan und Zirkonium;
   Me ausgewählt ist aus Zink, Magnesium und einer Mischung aus Zink und Magnesium wobei die Gehalte der Matrixkomponenten so gewählt sind, dass eine Zusammensetzung ausgebildet ist, die innerhalb der morphotropen Phase zwischen einer ferroelektrischen und einer nicht-ferroelektrischen Phase vorliegt.

2. Piezoelektrische Keramikzusammensetzung nach dem vorhergehenden Anspruch,
   wobei die Zusammensetzung das Matrixmaterial und ein Additiv umfasst, wobei das Additiv ein Metalloxid ist, oder aus dem Matrixmaterial und dem Additiv besteht.

3. Piezoelektrische Keramikzusammensetzung nach Anspruch 1 oder 2, umfassend ein oder bestehend aus einem Matrixmaterial der Formel:

   k $(Bi_{0,5}A_{0,5})EO_3$ - 1 $BaEO_3$ - m $Bi(Me_{0,5}E_{0,5})O_3$,
   wobei

$$0 \leq k \leq 0,96,$$

$$0 \leq l \leq 0,96,$$

$$0,04 \leq m \leq 0,15$$

und

$$k+l+m = 1.$$

4. Piezoelektrische Keramikzusammensetzung nach dem vorhergehenden Anspruch, umfassend ein oder bestehend aus einem Matrixmaterial und einem Additiv, wobei die Zusammensetzung folgende Formel besitzt:

a [k $(Bi_{0,5}A_{0,5})EO_3$ - 1 $BaEO_3$ - m $Bi(Me_{0,5}E_{0,5})O_3$] - b $M_fO_g$,
wobei
M ausgewählt ist aus einwertigen Metallen, zweiwertigen Metallen und dreiwertigen Metallen und Mischungen davon,
wobei $M_fO_g$ das entsprechende Metalloxid $M_2O$, MO oder $M_2O_3$ darstellt,

$$a+b = 1$$

und wobei $0 < b \leq 3$ Gew.-% und $97 \leq a \leq 100$ Gew.-% der Keramikzusammensetzung.

5. Piezoelektrische Keramikzusammensetzung nach einem der vorhergehenden Ansprüche, wobei das Additiv ausgewählt ist aus Übergangsmetalloxiden, insbesondere MnO, CuO und ZnO.

6. Piezoelektrische Keramikzusammensetzung nach einem der vorhergehenden Ansprüche, wobei die Zusammensetzung eine effektive piezoelektrische Konstante $d_{33}$* größer als 350 pm/V aufweist, bevorzugt größer als 549 pm/V, ganz besonders bevorzugt größer als 750 pm/V aufweist.

7. Verfahren zur Herstellung einer piezoelektrischen Keramikzusammensetzung nach einem der vorhergehenden Ansprüche umfassend folgende Schritte:

A) Bereitstellen von Pulvern von Metallsalzen der Metalle, die in der ersten Matrixkomponente und jeder weiteren Matrixkomponente oder jedes Additivs in der Keramikzusammensetzung enthalten sind, wobei die Anionen der Metallsalze ausgewählt sind aus Oxiden, Anionen, die mittels Kalzinierung zumindest teilweise in Oxide umwandelbar sind oder umgewandelt werden , und Mischungen davon, wobei weiterhin der Gehalt der Rohpartikel gemäß der Stöchiometrie der Formel für die entsprechende Komponente oder das entsprechende Additiv ausgewählt wird;
B) Formgebung und Sintern der erhaltenen Mischung.

8. Verfahren nach dem vorhergehenden Anspruch, wobei zwischen Schritt A) und B) der folgende Schritt ausgeführt wird:

C) Kalzinieren der Mischung von im Schritt A) bereitgestellten Pulvern.

9. Verfahren nach einem der beiden vorhergehenden Ansprüche, wobei die Metallsalze aus Oxiden, Hydroxiden, Carbonaten, Nitraten, Hydraten und ähnlichen Verbindungen ausgewählt werden.

10. Verfahren nach einem der drei vorhergehenden Ansprüche, wobei das Sintern bei Temperaturen zwischen 950°C und 1200°C, beispielsweise zwischen 1000°C und 1150°C, ausgeführt wird.

11. Elektrisches Bauelement umfassend eine piezoelektrische Keramikzusammensetzung nach einem der Ansprüche 1 bis 6.

**Claims**

1.  Piezoelectric ceramic composition comprising a matrix material comprising at least three matrix components having a perovskite structure or consisting of said matrix components, wherein the first matrix component is $(Bi_{0.5}A_{0.5})EO_3$, a second matrix component is $BaEO_3$, and a third matrix component is $Bi(Me_{0.5}E_{0.5})O_3$, A is selected from an alkali metal, particularly sodium or potassium, or a mixture of alkali metals; E is independently selected from titanium, zirconium and mixtures of titanium and zirconium;
    Me is selected from zinc, magnesium and a mixture of zinc and magnesium, wherein the contents of the matrix components are chosen so as to form a composition within the morphotropic phase between a ferroelectric and a non-ferroelectric phase.

2.  Piezoelectric ceramic composition according to the preceding claim, wherein the composition comprises the matrix material and an additive, the additive being a metal oxide, or consists of said matrix material and said additive.

3.  Piezoelectric ceramic composition according to Claim 1 or 2, comprising or consisting of a matrix material represented by the formula: $k (Bi_{0.5}A_{0.5})EO_3 - 1 BaEO_3 - m Bi (Me_{0.5}E_{0.5})O_3$ wherein

$$0 \leq k \leq 0.96, \quad 0 \leq 1 \leq 0.96, \quad 0.04 \leq m \leq 0.15$$

and

$$k+1+m = 1.$$

4.  Piezoelectric ceramic composition according to the preceding claim, comprising or consisting of a matrix material and an additive, the composition represented by the following formula:

    $a [k (Bi_{0.5}A_{0.5})EO_3 - 1 BaEO_3 - m Bi(Me_{0.5}E_{0.5})O_3] - b M_fO_g$
    wherein
    M is selected from monovalent metals, bivalent metals and trivalent metals and mixtures thereof, wherein $M_fO_g$ represents the corresponding metal oxide $M_2O$, MO or $M_2O_3$, a+b = 1 and wherein $0 < b \leq 3$ weight% and $97 \leq a \leq 100$ weight% of the ceramic composition.

5.  Piezoelectric ceramic composition according to any of the preceding claims, wherein the additive is selected from transition metal oxides, particularly MnO, CuO and ZnO.

6.  Piezoelectric ceramic composition according to any of the preceding claims, wherein the composition exhibits an effective piezoelectric constant $d_{33}*$ greater than 350 pm/V, preferably greater than 549 pm/V, more preferably greater than 750 pm/V.

7.  Method for preparing a piezoelectric ceramic composition according to any of the preceding claims, comprising the following steps:

    A) Providing powders of metal salts of the metals contained in the first matrix component and any further matrix component or additive comprised in the ceramic composition, wherein the anions of the metal salts are selected from oxides, anions being at least partially convertible or converted into oxides upon calcination and mixtures thereof, wherein further the content of the raw particles is chosen according to the stoichiometry of the formula for the corresponding component or additive;
    B) Shape forming and sintering of the obtained mixture.

8.  Method according to the preceding claim, wherein between step A) and B) the following step is carried out:

    C) Calcining the mixture of powders provided in step A).

9.  Method according to any of the two preceding claims, wherein the metal salts are selected from oxides, hydroxides, carbonates, nitrates, hydrates and similar compounds.

**10.** Method according to any of the three preceding claims, wherein the sintering is carried out at temperatures between 950 °C and 1200 °C, for example between 1000 °C and 1150 °C.

**11.** Electrical component comprising a piezoelectric ceramic composition according to any one of Claims 1 to 6.


**Revendications**

**1.** Composition céramique piézoélectrique comprenant un matériau de matrice, comprenant au moins trois composants de matrice pourvus d'une structure de pérovskite ou constitué par ces trois composants de matrice, le premier composant de matrice étant le $(Bi_{0,5}A_{0,5})EO_3$, un deuxième composant de matrice étant le $BaEO_3$ et un troisième composant de matrice étant le $Bi(Me_{0,5}E_{0,5})O_3$,

A étant choisi parmi un métal alcalin, en particulier le sodium ou le potassium, ou un mélange de métaux alcalins ;
E étant choisi, indépendamment, parmi le titane, le zirconium et les mélanges de titane et de zirconium ;
Me étant choisi parmi le zinc, le magnésium et un mélange de zinc et de magnésium, les teneurs des composants de matrice étant choisies de manière telle qu'il se forme une composition qui se trouve dans la phase morphotrope entre une phase ferroélectrique et une phase non ferroélectrique.

**2.** Composition céramique piézoélectrique selon la revendication précédente, la composition comprenant le matériau de matrice et un additif, l'additif étant un oxyde métallique, ou étant constituée par le matériau de matrice et l'additif.

**3.** Composition céramique piézoélectrique selon la revendication 1 ou 2, comprenant ou constituée par un matériau de matrice de formule :

$k(Bi_{0,5}A_{0,5})EO_3$-1 $BaEO_3$-m $Bi(Me_{0,5}E_{0,5})O_3$, dans laquelle

$$0 \leq k \leq 0{,}96,$$

$$0 \leq l \leq 0{,}96,$$

$$0{,}04 \leq m \leq 0{,}15$$

et

$$k + l + m = 1.$$

**4.** Composition céramique piézoélectrique selon la revendication précédente, comprenant ou constituée par un matériau de matrice et un additif, la composition présentant la formule suivante :

$a[k(Bi_{0,5}A_{0,5})EO_3 - 1\ BaEO_3 - m\ Bi(Me_{0,5}E_{0,5})O_3]$-b $M_fO_g$, dans laquelle

M est choisi parmi les métaux monovalents, les métaux divalents et les métaux trivalents et leurs mélanges, $M_fO_g$ représentant l'oxyde métallique $M_2O$, MO ou $M_2O_3$ correspondant,

$$a + b = 1$$

et $0 < b \leq 3\%$ en poids et $97 \leq a \leq 100\%$ en poids de la composition céramique.

**5.** Composition céramique piézoélectrique selon l'une quelconque des revendications précédentes, l'additif étant choisi parmi les oxydes de métaux de transition, en particulier le MnO, le CuO et le ZnO.

6. Composition céramique piézoélectrique selon l'une quelconque des revendications précédentes, la composition présentant une constante piézoélectrique effective $d_{33}*$ supérieure à 350 pm/V, de préférence supérieure à 549 pm/V, de manière tout particulièrement préférée supérieure à 750 pm/V.

7. Procédé pour la préparation d'une composition céramique piézoélectrique selon l'une quelconque des revendications précédentes, comprenant les étapes suivantes consistant à :

A) préparer des poudres de sels métalliques des métaux, qui sont contenus dans le premier matériau de matrice et dans chaque autre composant de matrice ou dans chaque additif dans la composition céramique, les anions des sels métalliques étant choisis parmi les oxydes, les anions qui peuvent être transformés ou qui ont été transformés au moins partiellement en oxydes par calcination et leurs mélanges, la teneur en particules brutes étant en outre choisie en fonction de la stoechiométrie de la formule pour le composant correspondant ou l'additif correspondant ;
B) façonner et fritter le mélange obtenu.

8. Procédé selon la revendication précédente, l'étape suivante étant réalisée entre l'étape A) et l'étape B) :

C) calciner le mélange des poudres préparées dans l'étape A).

9. Procédé selon l'une quelconque des deux revendications précédentes, les sels métalliques étant choisis parmi les oxydes, les hydroxydes, les carbonates, les nitrates, les hydrates et des composés analogues.

10. Procédé selon l'une quelconque des trois revendications précédentes, le frittage étant réalisé à des températures entre 950°C et 1200°C, par exemple entre 1000°C et 1150°C.

11. Composant électrique, comprenant une composition céramique piézoélectrique selon l'une quelconque des revendications 1 à 6.

FIG 1(a)

FIG 1(b)

## FIG 2(a)

## FIG 2(b)

FIG 3(a)

FIG 3(b)

FIG 4(a)

FIG 4(b)

## FIG 5(a)

## FIG 5(b)

FIG 6(a)

FIG 6(b)

FIG 7(a)

FIG 7(b)

## FIG 8(a)

## FIG 8(b)

## FIG 9(a)

## FIG 9(b)

## FIG 10

## FIG 11(a)

## FIG 11(b)

FIG 11(c)

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 2005047748 A
- JP 2005047746 A
- US 2008237531 A1

- JP 2008098627 A
- JP 2005047745 A


**In der Beschreibung aufgeführte Nicht-Patentliteratur**

- **Y. SAITO et al.** Lead-Free Piezoceramics. *Nature,* 2004, vol. 432 (4), 84-7
- **S.T. ZHANG et al.** Giant strain in lead-free piezoceramics Bi0.5Na0.5TiO3-BaTiO3-K0.5Na0.5NbO3 (BNT-BT-KNN)-system. *Applied Physics Letters,* 2007, vol. 91, 112906
- Phase transitions and dielectric properties in Bi(Zn1/2Ti1/2)O3â BaTiO3 perovskite solid solutions. **CHIEN-CHIH HUANG et al.** JOURNAL OF APPLIED PHYSICS. AMERICAN INSTITUTE OF PHYSICS, 30. Juli 2008, vol. 104, 24117-1, 24117-4

- **CHIEN-CHIH HUANG et al.** Phase transitions and dielectric properties in Bi(Zn1/2Ti1/2)O3-ABO3 perovskite solid solutions. *APPLICATIONS OF FERROELECTRICS, 2008. ISAF 2008. 17TH IEEE INTERNATIONAL SYMPOSIUM,* 23. Februar 2008, 1-3
- **CHIEN-CHIH HUANG et al.** Structure and ferroelectric properties of Bi(Zn1/2Ti1/2)03-(Bi1/2K1/2)TiO3 perovskite solid solutions. *IEEE TRANSACTIONS ON ULTRASONICS, FERROELECTRICS AND FREQUENCY CONTROL,* 01. Juli 2009, vol. 56 (7), 1304-1308
- **WANG L. et al.** Dielectric and Piezoelectric Properties of lead-free BaTiO3-Bi(Zn0.5Ti0.5)O3 and (Bi0.5Na0.5)TiO3-Bi(Zn0.5Ti0.5)O3 Ceramics. *FERROELECTRICS,* 01. Januar 2009, vol. 380, 177-182